# EUROPEAN PATENT SPECIFICATION

(11) **EP 2 971 219 B1**
(45) Date of publication and mention of the grant of the patent: **28.03.2018**
(21) Application number: 13814393.8
(22) Date of filing: 13.12.2013
(51) Int. Cl.: C23C 10/14, C23C 10/16, C23C 16/44, C23C 28/02, F01D 5/28

(54) **ADVANCED BOND COAT**
ERWEITERTE HAFTBESCHICHTUNG
COUCHE D'ANCRAGE AMÉLIORÉE

(30) Priority: 15.03.2013 US 201361790201 P
(43) Date of publication of application: 20.01.2016
(73) Proprietor: Rolls-Royce Corporation, Indianapolis, Indiana 46225-1103 (US)
(72) Inventor: LEE, Kang N., Zionsville, Indiana 46077 (US)
(74) Representative: HGF Limited
(86) International application number: PCT/US2013/075136
(87) International publication number: WO 2014/143257

(56) References cited:
- EP-A1- 0 784 104
- EP-A1- 1 652 968
- EP-A1- 2 199 424
- EP-A2- 1 767 666
- EP-A2- 1 767 667
- US-A1- 2005 118 453
- US-A1- 2010 330 295

## Description

### TECHNICAL FIELD

The present disclosure generally relates to high temperature coatings.

### BACKGROUND

Present approaches to high temperature coatings suffer from a variety of drawbacks, limitations, disadvantages and problems including those respecting substrate compatibility and others. There is a need for the unique and inventive coating apparatuses, systems and methods disclosed herein.

EP2199424 discloses a static chemical vapor deposition (CVD) process may be used to deposit a coating including a γ-Ni + γ'-Ni₃Al phase constitution over a substrate. A static CVD process is performed in a closed system that may include the substrate, and coating material and an activator. The γ-Ni + γ'-Ni₃Al coating may be modified by one or more additional elements, including, for example, Hf, Y, Zr, Ce, La, Si, Cr, or additional elements present in the substrate. A static CVD process may include codeposition of two or more elements, and may also include sequential static CVD steps, each of which is performed in a closed system.

### SUMMARY

Viewed from one aspect, there is provided an article comprising a substrate and a coating system as set forth in claim 1 of the appended claims. Viewed from another aspect, there is provided a method as set forth in claim 10 of the appended claims.

In some examples, the disclosure describes coating system including less than about 55 atomic percent aluminum, between about 10 and about 25 atomic percent of a platinum group metal, and a balance nickel; at least one of chromium, silicon, tantalum, or cobalt, a reactive element; and diffusion impurities. In accordance with these examples, the coating system comprises a discrete gamma-prime Ni₃Al region and a discrete beta NiAl region.

The coating system comprises a gamma-prime Ni₃Al layer anda beta NiAl layer which are discrete dual layers.

The disclosure describes a method including positioning a substrate and a precursor in a sealed vessel. The precursor comprises at least one of a solid halide or a combination of a halide activator and a donor. The method includes vacuum purging and backfilling the sealed vessel, heating the substrate and the precursor in the sealed vessel to generate a coating gas from the precursor, and reacting the coating gas with the substrate to form a discrete dual region coating including a first region of gamma-prime Ni₃Al and a second region of beta NiAl

### BRIEF DESCRIPTION OF THE FIGURES

Fig. 1 is a conceptual cross-sectional diagram illustrating an example coating system including gamma-prime and beta phase discrete dual regions.
Fig. 2 is a cross-section of an example coating system including gamma-prime and beta phase discrete dual regions.
Fig. 3 is flow diagram illustrating an example coating technique for forming a coating system including gamma-prime and beta phase discrete dual regions.
Fig. 4a is a cross-section of an example gamma-prime and beta phase discrete dual region coating modified with platinum and a reactive element showing negligible hot corrosion attack.
Fig. 4b is a cross-section of an example beta phase coating in which about 25% of the beta coating was penetrated by hot corrosion attack.

### DETAILED DESCRIPTION

For the purposes of promoting an understanding of the principles of the disclosure, reference will now be made to the examples illustrated in the drawings and specific language will be used to describe the same. Any alterations and further modifications in the described examples, and any further applications of the principles of the disclosure as described herein are contemplated as would normally occur to one skilled in the art to which the disclosure relates.

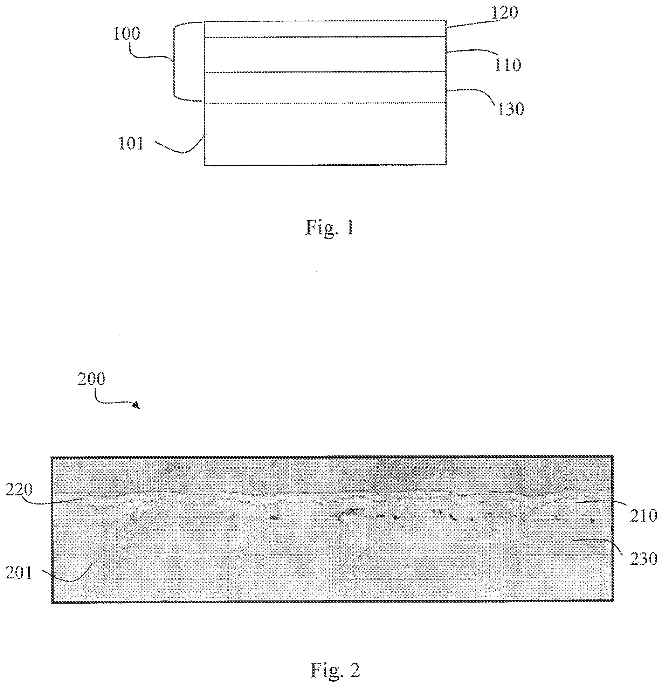

Fig. 1 is a conceptual cross-sectional diagram illustrating an example coating system 100 including gamma-prime and beta phase discrete dual regions. Coating system 100 is shown on a substrate 101. Coating system 100 includes an alloy of nickel and aluminum. The alloy of coating system 100 has gamma-prime Ni₃Al and beta NiAl phases, and the beta NiAl phase layer 120 is disposed on the gamma-prime Ni₃Al phase layer 110 creating a discrete dual region coating system. In some examples, one or both phase layers 110 and 120 can be modified by a platinum group metal and/or reactive element such as hafnium, yttrium, zirconium, chromium, and silicon. The platinum group metal and reactive element can enhance hot corrosion resistance and thermal barrier characteristics.

As shown in Fig. 1, in some examples, a transition zone 130 can be present when coating system 100 is deposited on substrate 101. In some examples, substrate 101 may include a high temperature superalloy. In some examples, transition zone 130 can be located between the gamma-prime Ni₃Al phase layer 110 and substrate 100. In some examples, transition zone 130 includes a gamma Ni/gamma-prime Ni₃Al region. Coating system 100 can include a barrier coating with a composition and morphology selected for mechanical compatibility with a substrate and long term oxidation resistance.
Fig. 2 is a cross-section of an example coating system including gamma-prime and beta phase discrete dual regions. In the example illustrated in Fig. 2, both a gamma-prime Ni₃Al layer 210 and a beta NiAl layer 220 are modified by platinum and a reactive element. In Fig. 2, coating system 200 includes a gamma-prime Ni₃Al layer 210 and a beta NiAl layer 220. Gamma-prime Ni₃Al layer 210 and beta NiAl layer 220 are discrete dual regions on substrate 201. A transition zone 230 of gamma-Ni and gamma-prime Ni₃Al phases is present between gamma-prime Ni₃Al layer 210 and substrate 201.

In some examples, with a discrete dual region coating system, elements of the coating alloy can be non-homogeneous throughout the coating. For example, the aluminum content (e.g,. atomic percent) may vary from the outer surface of coating system 100 (Fig. 1) to the region adjacent substrate 101. A gamma-prime Ni₃Al phase, the region adjacent substrate 101, has an aluminum atomic percent of less than 25 at%. A beta NiAl phase, the region at the outer surface of coating system 100, has an aluminum atomic percent of between 25 at% and about 60 at%. The aluminum atomic percent varies from less than 25 at% to greater than 25 at% through the thickness of coating system 100.

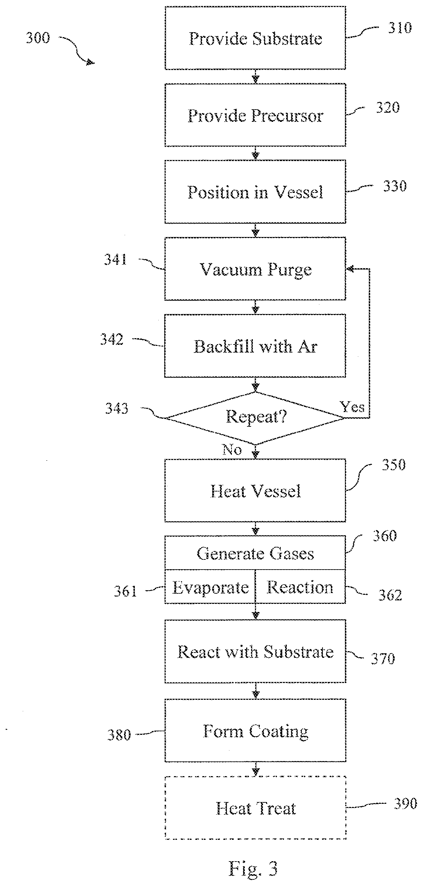

In some examples, coating system 100 may be formed using a static chemical vapor deposition process 300, such as the example technique illustrated in the flow diagram of Fig. 3. Static CVD process 300 includes providing a substrate (310). The substrate can be a high temperature superalloy (e.g., substrate 101, Fig. 1). In some examples, the substrate can also be part of a turbine blade or vane.

Static CVD process 300 also includes providing a coating precursor (320). In some examples, a coating precursor can be a solid halide or a combination of a halide activator and a donor, containing coating element(s). The technique further includes placing the substrate and the coating precursor in a sealed vessel (330). Positioning of the substrate and precursor in the sealed vessel can be adjusted for a selected coating composition, thickness and microstructure. The coating system thickness (e.g., the thickness of coating system 100) can vary with the parameters of static CVD process 300. A substrate which is internal to a component can also be coated where the coating gases are directed to the internal surface using a gas feeding fixture.

Static CVD process 300 further includes vacuum purging the vessel (341); and, backfilling the vessel with high purity argon (342). It is then determined whether the vacuum purging (341) and backfilling (342) are to be repeated (343). In some examples, the purge and backfill sequence can be repeated several times. The repetition of this sequence can minimize the oxygen content in the sealed vessel. The vessel then can be heated (350) to a temperature selected to generate coating gas(es) by various mechanisms. The temperature can be between about 1500°F (about 815°C)and about 1900°F (about 1038°C). For example, the temperature can be between about 1600°F (about 871°C) and about 1800°F (about 982°C).

A coating gas is then generated (360) by the heating (350). In some examples, generating the coating gas (360) includes evaporating a solid halide . In some examples, generating the coating gas (360) includes includes facilitating an activator-donor reaction (362) to generate the coating gases. The coating gases subsequently react with one or more substrate elements (370). This reaction form a coating system (e.g., coating system 100) with gamma-prime Ni₃Al /beta NiAl discrete dual regions (380). In some examples, the coating process can have a duration of up to 10 hours, such as a duration of between about 1 hour and about 3 hours. In some examples, static CVD process 300 can include an optional post-deposition heat treatment (390).

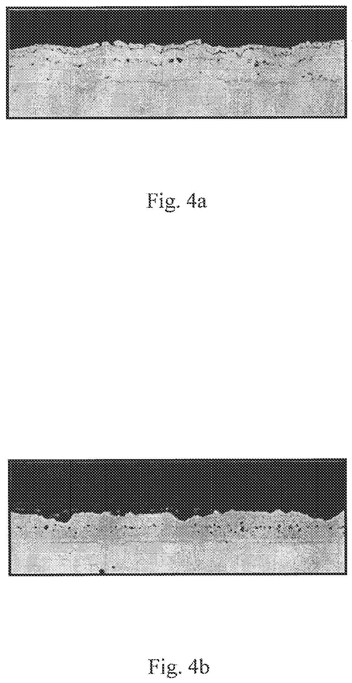

In high temperature coatings, aluminum can provide a reservoir for supplying aluminum to form a protective alumina scale, which provides oxidation resistance. A beta-NiAl phase coating has a high level of aluminum that can provide the reservoir of aluminum for long term oxidation resistance. A gamma-prime Ni₃Al phase between the beta-NiAl phase and the substrate appears to restrict the formation of microstructural instabilities at the coating/substrate interface and suppress the extent of aluminum diffusion into the substrate. Fig 4a is a cross-section of an example gamma-prime Ni₃Al and beta NiAl phase discrete dual region coating modified with platinum and a reactive element showing negligible hot corrosion attack. Fig. 4b is a cross-section of a beta NiAl phase coating where about 25% of the beta coating was penetrated by hot corrosion attack.

An example composition of the discrete dual regions of a coating system of the present application can include the following.

### Gamma-prime coating composition:

Up to 25 atomic percent (at. %) (such as between about 10 at. % and about 22 at. %) aluminum
Up to 30 at. % (such as between about 10 at. % and about 20 at. %) platinum group metal
Up to 35 at. % (such as between about 10 at. % and about 30 at. %) chromium
Up to 5 at. % (such as between about 2 at. % and about 4 at. %) silicon
Up to 2 at. % (such as between about 0.01 at. % and about 1 at. %) reactive element
Diffusion products from substrate (Co, Ti, Mo, Re, Ta, W, etc.)
Balance Ni

### Beta coating composition:

Up to 55 at. % (such as between about 30 at. % and about 50 at. %) aluminum
Up to 30 at. % (such as between about 10 at. % and about 20 at. %) platinum group metal
Up to 35 at. % (such as between about 5 at. % and about 20 at. %) chromium
Up to 5 at. % (such as between about 2 at. % and about 4 at. %) silicon
Up to 2 at. % (such as between about 0.01 at. % ∼ 1 at. %) reactive element
Diffusion products from substrate (Co, Ti, Mo, Re, Ta, W, etc.)
Balance Ni

Additional elements that may be deposited for thermal barrier life and hot corrosion resistance include a platinum group metal and reactive elements such as hafnium, yttrium, zirconium, chromium, and silicon. The platinum group metal can be incorporated by electroplating the platinum on the substrate (e.g., substrate 101) and subsequently heat treating the platinum-plated substrate at a temperature sufficient to diffuse the platinum into the substrate. The aluminum and reactive elements can be deposited via the CVD steps of the coating process on the platinum diffused substrate.

Aluminum deposition can utilize a precursor of a solid AlCl₃ and/or a combination of a halide activator such as NH₄Cl, NH₄HF₂ or HCl, and an aluminum or Al-Cr alloy donor. The reactive element deposition can utilize a precursor of either a solid halide of the reactive element(s) or a combination of a halide activator and a reactive element or a reactive element-containing alloy donor. The resulting coating system may include discrete dual regions of a (Ni+Pt)₃Al gamma-prime phase and a NiPtAl beta phase modified with reactive elements. The coating system can also contain elements such as Co, Ti, Mo, Re, Ta, W, etc. which can diffuse from the substrate during the CVD step and post-CVD heat treatment step of the coating process.

In some examples, coating elements can be deposited simultaneously or co-deposited during the coating process. In other examples, coating elements can be deposited sequentially. In other examples, a portion of the coating elements can be simultaneously deposited and another portion of the coating elements can be sequentially deposited. Simultaneous or sequential deposition can be determined to provide a selected coating composition.

Some examples of coating processes can include:
Example 1: Al + (Hf, Zr, and/or Y) chemical vapor deposition (CVD)
Example 2: Cr CVD → Al + (Hf, Zr, and/or Y) CVD
Example 3: Hf CVD → Al + (Hf, Zr, and/or Y) CVD
Example 4: Cr CVD → (Hf, Zr, and/or Y) CVD → Al CVD
Example 5: Si CVD → Al + (Hf, Zr, and/or Y) CVD
Example 6: Si CVD → (Hf, Zr, and/or Y) CVD → Al CVD

In some examples, the disclosure describes an alloy including less than about 55 atomic percent aluminum; between about 10 and about 25 atomic percent of a platinum group metal; and a balance of the alloy being nickel, one or more of chromium, silicon, tantalum, cobalt, and a reactive element, and diffusion impurities; where the alloy has a discrete gamma-prime Ni₃Al region and a discrete beta NiAl region.

In some of these examples, the reactive element may include one or more of hafnium, yttrium, zirconium, lanthanum and cerium with an average of less than about 2 atomic percent or an average of less than 0.5 atomic percent. In some of these examples, the one or more of chromium, silicon, tantalum, and cobalt may include an average of less than about 35 atomic percent or an average of between about 5 and about 25 atomic percent. In some of these examples, an average of the atomic percent of aluminum may be non-homogenous through the alloy or a coating system. In some of these examples, the discrete gamma-prime Ni₃Al region and the discrete beta NiAl region of the alloy may include a coating system formed on a substrate. In some of these examples, the coating system may further include a transition zone between the substrate and the discrete gamma-prime Ni₃Al region, and the transition zone may further include a gamma-Ni phase and a gamma-prime Ni₃Al phase.

In some examples, the disclosure describes a coating system including a substrate; a first layer including a gamma-prime Ni₃Al composition; and a second layer including a beta NiAl composition; wherein the first layer and the second layer are discrete dual layers. In some of these examples, the gamma-prime Ni₃Al composition includes less than about 25 atomic percent aluminum, between about 10 and about 25 atomic percent of a platinum group metal, and a balance of the gamma-prime Ni₃Al composition may include nickel, one or more of chromium, silicon, tantalum, cobalt, and a reactive element, and diffusion impurities. In some of these examples the beta NiAl composition may include between about 25 and about 55 atomic percent aluminum, between about 10 and about 25 atomic percent of a platinum group metal, and the balance of the beta NiAl composition may include nickel, one or more of chromium, silicon, tantalum, cobalt, and a reactive element, and diffusion impurities.

In some of these examples, the first layer may include a platinum group metal modified gamma-prime Ni₃Al alloy and the second layer may include a platinum group metal modified beta NiAl alloy. In some of these examples, the first layer may include a reactive element modified gamma-prime Ni₃Al alloy and the second layer may include a reactive element modified beta NiAl alloy. In some of these examples, the substrate may include a high temperature superalloy. In some of these examples, the coating system may include a hot corrosion resistant coating and a thermal barrier coating. In some of these examples, a transition zone may be between the substrate and the first layer, and the transition zone can further include a gamma-Ni phase and a gamma-prime Ni₃Al phase.

In some examples, the disclosure describes a method including providing a substrate; providing a precursor; positioning the substrate and the precursor in a sealed vessel; vacuum purging and backfilling the sealed vessel; heating the substrate and the precursor in the sealed vessel; generating a coating gas from the precursor; reacting the coating gas with the substrate; and forming a discrete dual region coating including a first region of gamma-prime Ni₃Al and a second region of beta NiAl.

In some of these examples, forming the discrete dual region coating may include forming the first region of gamma-prime Ni₃Al including less than about 25 atomic percent aluminum; between about 10 and about 25 atomic percent of a platinum group metal; and a balance of the gamma-prime Ni₃Al being nickel, one or more of chromium, silicon, tantalum, cobalt, and a reactive element, and trace impurities. In some of these examples, forming the discrete dual region coating may include forming the second region of beta NiAl including between about 25 and about 55 atomic percent aluminum; between about 10 and about 25 atomic percent of a platinum group metal; and the balance of the beta NiAl being nickel, one or more of chromium, silicon, tantalum, cobalt, and a reactive element, and diffusion impurities.

In some of these examples, the substrate may include a high temperature superalloy. In some of these examples, the precursor may include a solid halide or a combination of a halide activator and a donor. In some of these examples, the method may further include electroplating a platinum group metal on the substrate, and forming the discrete dual region coating further includes forming a platinum group metal modified gamma-prime Ni₃Al and beta NiAl discrete dual region coating system. In some examples, the method may further include post-deposition heat treating the discrete dual region coating. In some of these examples, the method may include repeating the vacuum purging and backfilling. In some examples, the method may include depositing one or more elements of the discrete dual region coating in an order selected from a group consisting of simultaneous, co-deposited, sequential and combinations thereof.

It should be understood that while the use of words such as preferable, preferably, preferred or more preferred utilized in the description above indicate that the feature so described may be more desirable, it nonetheless may not be necessary and examples lacking the same may be contemplated as within the scope of the disclosure, the scope being defined by the claims that follow. In reading the claims, it is intended that when words such as "a," "an," "at least one," or "at least one portion" are used there is no intention to limit the claim to only one item unless specifically stated to the contrary in the claim. When the language "at least a portion" and/or "a portion" is used the item can include a portion and/or the entire item unless specifically stated to the contrary.

## Claims

1. An article comprising:
a substrate; and
a coating system on the substrate, wherein the coating system comprises:
a gamma-prime Ni₃Al layer; and
a beta NiAl layer directly on the gamma-prime Ni₃Al layer, wherein the gamma-prime Ni₃Al layer and the beta NiAl layer are discrete dual layers, and wherein the gamma-prime Ni₃Al is between the substrate and the beta NiAl layer.

2. The article of claim 1, wherein the gamma-prime Ni₃Al layer comprises:
less than 25 atomic percent aluminum;
between 10 and 5 atomic percent of a platinum group metal; and
a balance of nickel; at least one of chromium, silicon, tantalum, of cobalt; a reactive element comprising hafnium, yttrium, zirconium, lanthanum, or cerium; and diffusion impurities.

3. The article of claim 2, wherein the gamma-prime Ni₃Al layer comprises up to 5 atomic percent silicon.

4. The article of claim 2 or 3, wherein the gamma-prime Ni₃Al layer comprises up to 2 atomic percent of the reactive element.

5. The article of any one of claims 1 to 4, wherein the beta NiAl layer comprises:
between 25 and 55 atomic percent aluminum;
between 10 and 25 atomic percent of a platinum group metal; and
a balance of nickel; at least one of chromium, silicon, tantalum, or cobalt; a reactive element comprising hafnium, yttrium, zirconium, lanthanum, or cerium; and diffusion impurities.

6. The article of claim 5, wherein the beta NiAl layer comprises up to 35 atomic percent chromium.

7. The article of claim 5 or 6, wherein the beta NiAl layer comprises up to 5 atomic percent silicon.

8. The article of any one of claims 5 to 7, wherein the beta NiAl layer comprises up to 2 atomic percent of the reactive element.

9. The article of any one of claims 1 to 8, further including a transition zone between the substrate and the gamma-prime Ni₃Al layer, wherein the transition zone includes a gamma-Ni phase and a gamma-prime Ni₃Al phase.

10. A method comprising:
electroplating a platinum group metal on a substrate to form a platinum-plated substrate;
heat treating the platinum-plated substrate to form a platinum-diffused substrate;
positioning the platinum-diffused substrate and a precursor in a sealed vessel, wherein the precursor comprises at least one of a solid aluminum halide or a combination of a halide activator and an aluminum or Al-Cr alloy donor;
vacuum purging and backfilling the sealed vessel;
heating the platinum-diffused substrate and the precursor in the sealed vessel to a temperature between 815°C and 1038°C to generate a coating gas from the precursor;
reacting the coating gas with the platinum-diffused substrate to form a discrete dual layer coating including a gamma-prime Ni₃Al layer on the substrate and a beta NiAl layer on the gamma-prime Ni₃Al layer; and
post-deposition heat treating the coated, platinum-diffused substrate.

11. The method of claim 10, wherein the gamma-prime Ni₃Al layer includes:
less than 25 atomic percent aluminum;
between 10 and 25 atomic percent of a platinum group metal; and
a balance of nickel; at least one of chromium, silicon, tantalum, or cobalt; a reactive element comprising hafnium, yttrium, zirconium, lanthanum, or cerium; and diffusion impurities.

12. The method of claim 10 or 11, wherein the beta NiAl layer includes:
between 25 and 55 atomic percent aluminum;
between 10 and 25 atomic percent of a platinum group metal; and
a balance of nickel; at least one of chromium, silicon, tantalum, or cobalt; a reactive element comprising hafnium, yttrium, zirconium, lanthanum, or cerium; and diffusion impurities.

## Patentansprüche

1. Artikel, umfassend:
ein Substrat; und
ein Beschichtungssystem auf dem Substrat, wobei das Beschichtungssystem Folgendes umfasst:
eine Gamma-Strich-Ni₃Al-Schicht; und
eine Beta-NiAl-Schicht direkt auf der Gamma-Strich-Ni₃Al-Schicht, wobei die Gamma-Strich-Ni₃Al-Schicht und die Beta-NiAl-Schicht getrennte Doppelschichten sind und wobei die Gamma-Strich-Ni₃Al-Schicht sich zwischen dem Substrat und der Beta-NiAl-Schicht befindet.

2. Artikel nach Anspruch 1, wobei die Gamma-Strich-Ni₃Al-Schicht Folgendes umfasst:
weniger als 25 Atomprozent Aluminium;
zwischen 10 und 5 Atomprozent eines Platinmetalls; und
einem Rest Nickel; mindestens eines von Chrom, Silizium, Tantal oder Kobalt; ein reaktives Element, das Hafnium, Yttrium, Zirkonium, Lanthan oder Cer umfasst; und Diffusionsverunreinigungen.

3. Artikel nach Anspruch 2, wobei die Gamma-Strich-Ni₃Al-Schicht bis zu 5 Atomprozent Silizium umfasst.

4. Artikel nach Anspruch 2 oder 3, wobei die Gamma-Strich-Ni₃Al-Schicht bis zu 2 Atomprozent des reaktiven Elements umfasst.

5. Artikel nach einem der Ansprüche 1 bis 4, wobei die Beta-NiAl-Schicht Folgendes umfasst: zwischen 25 und 55 Atomprozent Aluminium;
zwischen 10 und 25 Atomprozent eines Platinmetalls; und
einem Rest Nickel; mindestens eines von Chrom, Silizium, Tantal oder Kobalt; ein reaktives Element, das Hafnium, Yttrium, Zirkonium, Lanthan oder Cer umfasst; und Diffusionsverunreinigungen.

6. Artikel nach Anspruch 5, wobei die Beta-NiAl-Schicht bis zu 35 Atomprozent Chrom umfasst.

7. Artikel nach Anspruch 5 oder 6, wobei die Beta-NiAl-Schicht bis zu 5 Atomprozent Silizium umfasst.

8. Artikel nach einem der Ansprüche 5 bis 7, wobei die Beta-NiAl-Schicht bis zu 2 Atomprozent des reaktiven Elements umfasst.

9. Artikel nach einem der Ansprüche 1 bis 8, ferner beinhaltend einen Übergangsbereich zwischen dem Substrat und der Gamma-Strich-Ni₃Al-Schicht, wobei der Übergangsbereich eine Gamma-Ni-Phase und eine Gamma-Strich-Ni₃Al-Phase beinhaltet.

10. Verfahren, umfassend:
Galvanisieren eines Platinmetalls auf ein Substrat, um ein platiniertes Substrat zu bilden;
Wärmebehandeln des platinierten Substrats, um ein mit Platin diffundiertes Substrat zu bilden; Positionieren des mit Platin diffundierten Substrats und eines Vorläufers in einem versiegelten Gefäß, wobei der Vorläufer mindestens eines von einem festen Aluminiumhalogenid oder einer Kombination eines Halogenidaktivators und eines Aluminium- oder Al-Cr-Legierungsdonors umfasst;
Vakuumreinigen und Hinterfüllen des versiegelten Gefäßes;
Erwärmen des mit Platin diffundierten Substrats und des Vorläufers im versiegelten Gefäß auf eine Temperatur zwischen 815 °C und 1038 °C, um ein Beschichtungsgas vom Vorläufer zu erzeugen;
Reagieren des Beschichtungsgases mit dem mit Platin diffundierten Substrat, um eine getrennte Doppelschichtbeschichtung zu bilden, die eine Gamma-Strich-Ni₃Al-Schicht auf dem Substrat und eine Beta-NiAl-Schicht auf der Gamma-Strich-Ni₃Al-Schicht beinhaltet; und
Nachabscheidungswärmebehandeln des beschichteten mit Platin diffundierten Substrats.

11. Verfahren nach Anspruch 10, wobei die Gamma-Strich-Ni₃Al-Schicht Folgendes beinhaltet: weniger als 25 Atomprozent Aluminium;
zwischen 10 und 25 Atomprozent eines Platinmetalls; und
einem Rest Nickel; mindestens eines von Chrom, Silizium, Tantal oder Kobalt; ein reaktives Element, das Hafnium, Yttrium, Zirkonium, Lanthan oder Cer umfasst; und Diffusionsverunreinigungen.

12. Verfahren nach Anspruch 10 oder 11, wobei die Beta-NiAl-Schicht Folgendes beinhaltet:
zwischen 25 und 55 Atomprozent Aluminium;
zwischen 10 und 25 Atomprozent eines Platinmetalls; und
einem Rest Nickel; mindestens eines von Chrom, Silizium, Tantal oder Kobalt; ein reaktives Element, das Hafnium, Yttrium, Zirkonium, Lanthan oder Cer umfasst; und Diffusionsverunreinigungen.

## Revendications

1. Article comprenant :
un substrat ; et
un système de revêtement sur le substrat, ledit système de revêtement comprenant :
une couche de gamma-prime-Ni₃Al ; et
une couche de bêta-NiAl directement sur la couche de gamma-prime-Ni₃Al, ladite couche de gamma-prime-Ni₃Al et ladite couche de bêta-NiAl étant des doubles couches discrètes, et ladite couche de gamma-prime-Ni₃Al se trouvant entre le substrat et la couche de bêta-NiAl.

2. Article selon la revendication 1, ladite couche de gamma-prime-Ni₃Al comprenant :
moins de 25 pour cent atomique d'aluminium ;
entre 10 et 5 pour cent atomique d'un métal du groupe du platine ; et
un complément de nickel ; au moins un élément parmi le chrome, le silicium, le tantale ou le cobalt ; un élément réactif comprenant du hafnium, de l'yttrium, du zirconium, du lanthane ou du cérium ; et des impuretés de diffusion.

3. Article selon la revendication 2, ladite couche de gamma-prime-Ni₃Al comprenant jusqu'à 5 pour cent atomique de silicium.

4. Article selon la revendication 2 ou 3, ladite couche de gamma-prime-Ni₃Al comprenant jusqu'à 2 pour cent atomique de l'élément réactif.

5. Article selon l'une quelconque des revendications 1 à 4, ladite couche de bêta-NiAl comprenant :
entre 25 et 55 pour cent atomique d'aluminium ;
entre 10 et 25 pour cent atomique d'un métal du groupe du platine ; et
un complément de nickel ; au moins un élément parmi le chrome, le silicium, le tantale ou le cobalt ; un élément réactif comprenant du hafnium, de l'yttrium, du zirconium, du lanthane ou du cérium ; et des impuretés de diffusion.

6. Article selon la revendication 5, ladite couche de bêta-NiAl comprenant jusqu'à 35 pour cent atomique de chrome.

7. Article selon la revendication 5 ou 6, ladite couche de bêta-NiAl comprenant jusqu'à 5 pour cent atomique de silicium.

8. Article selon l'une quelconque des revendications 5 à 7, ladite couche de bêta-NiAl comprenant jusqu'à 2 pour cent atomique de l'élément réactif.

9. Article selon l'une quelconque des revendications 1 à 8, comportant en outre une zone de transition entre le substrat et la couche de gamma-prime-Ni₃Al, ladite zone de transition comprenant une phase de gamma-Ni et une phase de gamma-prime-Ni₃Al.

10. Procédé comprenant :
l'électrodéposition d'un métal du groupe du platine sur un substrat pour former un substrat plaqué au platine ;
le traitement thermique du substrat plaqué au platine pour former un substrat diffusé de platine ;
le placement du substrat diffusé de platine et d'un précurseur dans un récipient étanche, ledit précurseur comprenant au moins un composé parmi un halogénure d'aluminium solide ou une combinaison d'un activateur d'halogénure et d'un donneur d'aluminium ou d'alliage Al-Cr ;
la purge sous vide et le remplissage du récipient étanche ;
le chauffage du substrat diffusé de platine et du précurseur dans le récipient étanche jusqu'à une température comprise entre 815°C et 1038°C pour générer un gaz de revêtement à partir du précurseur ;
la mise en réaction du gaz de revêtement avec le substrat diffusé de platine pour former un revêtement à double couche discrète comportant une couche de gamma-prime-Ni₃Al sur le substrat et une couche de bêta-NiAl sur la couche de gamma-prime-Ni₃Al ; et
le traitement à chaud après dépôt du substrat enduit diffusé de platine.

11. Procédé selon la revendication 10, ladite couche de gamma-prime-Ni₃Al comportant :
moins de 25 pour cent atomique d'aluminium ;
entre 10 et 25 pour cent atomique d'un métal du groupe du platine ; et
un complément de nickel ; au moins un élément parmi le chrome, le silicium, le tantale ou le cobalt ; un élément réactif comprenant du hafnium, de l'yttrium, du zirconium, du lanthane ou du cérium ; et des impuretés de diffusion.

12. Procédé selon la revendication 10 ou 11, ladite couche de bêta-NiAl comportant :
entre 25 et 55 pour cent atomique d'aluminium ;
entre 10 et 25 pour cent atomique d'un métal du groupe du platine ; et
un complément de nickel ; au moins un élément parmi le chrome, le silicium, le tantale ou le cobalt ; un élément réactif comprenant du hafnium, de l'yttrium, du zirconium, du lanthane ou du cérium ; et des impuretés de diffusion.
